(19) Europäisches Patentamt
European Patent Office
Office européen des brevets

(11) **EP 0 616 050 B1**

(12) **EUROPÄISCHE PATENTSCHRIFT**

(45) Veröffentlichungstag und Bekanntmachung des Hinweises auf die Patenterteilung:
**13.08.1997 Patentblatt 1997/33**

(51) Int Cl.6: **C23C 28/04**, C23C 14/06

(21) Anmeldenummer: **94103656.8**

(22) Anmeldetag: **10.03.1994**

(54) **Verfahren zur Standzeiterhöhung von Werkzeugen und Verschleissschutz-beschichtetes Werkzeug**

Process for increasing the durability of tools, and wear-resistant coated tool

Procédé d'augmentation de résistance des outils et outils avec revêtement anti-usure

(84) Benannte Vertragsstaaten:
**BE CH DE ES FR GB IT LI NL SE**

(30) Priorität: **16.03.1993 CH 790/93**

(43) Veröffentlichungstag der Anmeldung:
**21.09.1994 Patentblatt 1994/38**

(73) Patentinhaber: **BALZERS AKTIENGESELLSCHAFT**
**9496 Balzers (LI)**

(72) Erfinder: **Kaufmann, Helmut**
**FL-9495 Triesen (LI)**

(74) Vertreter: **Troesch Scheidegger Werner AG Patentanwälte,**
**Siewerdtstrasse 95,**
**Postfach**
**8050 Zürich (CH)**

(56) Entgegenhaltungen:
EP-A- 0 470 359          FR-A- 2 110 202
GB-A- 2 110 246          GB-A- 2 226 334

- **CHEMICAL ABSTRACTS, vol. 93, no. 6, 22. September 1980, Columbus, Ohio, US; abstract no. 118218a, J.TACIJOWSKI ET AL 'properties of composite chromium and titanium carbide layers' Seite 211 ;Spalte 2 ;**

**Beschreibung**

Die vorliegende Erfindung betrifft ein Verfahren nach dem Oberbegriff von Anspruch 1 sowie ein Werkzeug nach dem Oberbegriff von Anspruch 6.

Die Gruppendefinition des Periodensystems entspricht derjenigen aus "CRC-Handbook of Chemistry and Physics", 46th edition, 1964.

Es ist bekannt, dass die Schichthaftung von MeX-Schichten der eingangs definierten Art, wie beispielsweise von Titannitridschichten, dann optimal wird, wenn die damit beschichtete Substratoberfläche sehr sauber ist oder eine Me-Zwischenschicht, im angegebenen Beispiel eine Titan-Zwischenschicht, zwischen Werkzeugsubstrat und der MeX-Beschichtung eingebaut wird. Es sei hierzu verwiesen auf Stolz et al., Surface Engineering, 1989, Vol. 5, No. 4, 305, oder auf Jehn et al., Surface and Coatings Technology, Vol. 41, No. 2, 1990, 167.

Grund dafür wird in der optimalen Verankerung gesehen, die durch das epitaktische Wachstum des MeX, wie des Titannitrides, auf den Primärkarbiden des Werkzeugsubstrates, üblicherweise Stahl, stattfindet. Hierzu sei verwiesen auf Helmersson et al., J.Vac.Sci.Technol. A3, 1985, 308. Bezüglich weiterer Werkzeugbeschichtungen sei verwiesen auf GB-A-2 226 334, EP-A-0 470 359, GB-A-2 110 246, FR-A-2 110 202 und auf "Chemical Abstracts", Vol. 93, Nr. 12, 22. Sept. 1980, Columbus, Ohio, US, abstract Nr. 118 218a: J. Tacikowski et al., "Properties of composite chromium and titanium carbide layers", p. 211, Spalte 2; Metalozn. Obrobka Cieplna Bd. 42, 1979, POL, p. 22-7.

Die vorliegende Erfindung geht von der Erkenntnis aus, dass die Messung der Haftung von Verschleissschutzschichten an Werkzeugen, wie beispielsweise das anhand der Beispiele noch zu Beschreibende, keine gesicherten Aussagen über die mit den erwähnten Werkzeugen zu erwartenden Standzeiten erlaubt. Dabei ist aber eine gute Schichthaftung für Werkzeugbeschichtungen unabdingbar.

Die Aufgabe der vorliegenden Erfindung, an Werkzeugen der genannten Art die Standzeiten zu erhöhen, wird gelöst durch das Verfahren, welches sich nach dem kennzeichnenden Teil von Anspruch 1 auszeichnet, bzw. durch ein Werkzeug, welches sich nach dem kennzeichnenden Teil von Anspruch 6 auszeichnet.

Es wird nachfolgend anhand der Beispiele gezeigt werden, dass durch das erfindungsgemässe Vorgehen massgebliche Standzeiterhöhungen erzielt wurden, obwohl Haftprüfungen mit bekannten Haftprüfverfahren diesbezüglich keine Verbesserungen oder sogar Verschlechterungen erwarten liessen. Vorsehen von Chromzwischenschichten sind in der Beschichtungstechnik zwar bekannt, ihr Einsatz beschränkt sich aber auf Schicht/Substratkombinationen mit geringer metallurgischer Affinität, wie auf Metall/Keramik-Systeme, wozu auf O.S. Heavens, Le Journal de Physique et le Radium, 11, 1950, 355, auf D.M. Mattox, Thin Solid Films, 18(1973), 173, verwiesen sei oder, wie beispielsweise auf Wolfram-Metallsysteme, wozu beispielsweise auf Bergmann, Farges, Bosch, 14th International Conference, San Diego, 1987, Wear (1989), verwiesen sei.

Die auch aufgrund von Hafttestverfahren unerwartete Lösung der der vorliegenden Erfindung zugrundeliegenden Aufgabe, nämlich an Werkzeugen der genannten Art die Standzeiten zu erhöhen, lässt sich vermutlich dadurch erklären, dass bei Schichten MeX mit an sich sehr guter Haftung nicht mehr die gute Haftung für die Standzeit der Grenzfläche zwischen Werkzeug und Schicht massgeblich ist, sondern die optimale Unterdrückung der Epitaxie, welch letztere zu einer Verminderung der Zähigkeit des Materialverbundes führt. Diese Unterdrückung wird dabei vermutlich gerade durch Zwischenschicht-Werkstoffe besonders gut erreicht, welche keine ausgeprägte metallurgische Affinität zum MeX-Schichtwerkstoff aufweisen und damit keine Haftungserhöhung ergeben.

Die Erfindung wird anschliessend anhand von Beispielen erläutert:

Beispiel 1:

Es wurden vierschneidige Schaftfräser des Durchmessers 16mm der Firma Fraisa, Typ 0110, mit einem reaktiven Bedampfungsverfahren, wie beispielsweise in der DE-PS-28 23 876, entsprechend der US-A-4 197 175, bzw. in der EP-A-0 490 068, entsprechend der US-A-5 229 570 beschrieben, d.h. durch Niedervolt-Bogenentladungsverdampfen mit Titannitrid beschichtet. Hierzu wurde die von der Anmelderin vertriebene Anlage BAI 830 MF eingesetzt. Dabei wurden vorerst die Werkstücke mit einem dichten Plasmastrahl, wie in der EP-A-0 484 704, entsprechend der US-A-5 250 779 beschrieben, während 80 min beheizt. Darnach wurden insbesondere die nachmals zu beschichtenden Oberflächen im genannten Plasmastrahl während 20 min geätzt. Daraufhin wurde mit der Niedervolt-Bogenentladung Titan in einer Stickstoffatmosphäre verdampft und auf die Werkzeuge die übliche, goldgelbe Titannitridschicht abgelegt. Dabei wurde in bekannter Art und Weise durch die Verfahrensführung eine metallische-Me-Titanunterschicht abgeschieden mit einer Dicke d < 1nm, die mithin so dünn ist, dass sie die Epitaxie-Effekte zwischen den Mikrokristallen des Substrates und der darüber aufwachsenden Titannitridschicht nicht unterbricht. Die TiN-Schicht wies eine Dicke von ca. 4μm auf.

Es wurden dann identische Werkzeugsubstrate identisch beschichtet, wobei aber auf das zu verdampfende Titan eine 3g-schwere Chromtablette aufgelegt wurde. Die Stickstoffzuführung wurde bereits begonnen, kurz bevor Titan verdampft wurde. Es entstand eine ca. 50nm dicke Cr- bzw. CrN-Schicht, über welcher die ca. 4μm dicke Titannitrid-

schicht abgelegt wurde. An den Schaftfräsern mit und ohne Chromzwischenschicht wurden einerseits Fräsversuche durchgeführt, um die Standzeiten zu ermitteln, anderseits Haftprüfungen vorgenommen. Folgende Fräsbedingungen wurden eingestellt:

Fräsbedingungen für Standzeitvergleich

| Fräsmaschine : | |
|---|---|
| Universalfräsmaschine: | Maho 800 P |
| Spindelleistung: | 5.5kW |
| Drehzahlbereich: | 40-2000U/min (geometrisch gestuft: 1.25) |
| Vorschübe: | 10-750mm/min (stufenlos) |

| Kühlung : | |
|---|---|
| Sattstrahlkühlung: | durch 1 Rohr |
| Kühlschmiermittel: | Blasocut 2000 Universal |
| Konzentration: | 5% |

| Werkstoff des Werkstückes : | |
|---|---|
| Vergütungsstahl: | 42CrMo4 |
| Festigkeit: | $1100N/mm^2$ |

| Schnittdaten : | |
|---|---|
| Schnittgeschwindigkeit: | V = 40m/min |
| Vorschub: | f = 0.35mm/U |
| | |
| Radiale Zustellung gemäss Fig. 4 ae: | 2.5mm |
| Axiale Zustellung gemäss Fig. 4 ap: | 15mm |
| Laufrichtung gemäss ω Fig. 4: | Gleichlauf |

Die Haftprüfung wurde mit dem Ritztest mit Rockwelldiamant unter Belastungen von 3, 5, 8 und 10kg vorgenommen. Im weiteren wurde auch der Rockwell-Eindrucktest unter Belastung von 150kg vorgenommen. Sowohl beim Rockwell-Eindrucktest wie auch beim Ritztest wurden keine Unterschiede an den unterschiedlich beschichteten Schaftfräsern festgestellt. Bei beiden Beschichtungsarten der Schaftfräser wurden beim Ritztest Belastungen von 10kg überschritten. Als Versagekriterium wurde das Auftreten von halbmondförmigen Ausbrüchen am Rande des durch die plastische Ritz-Deformation erzeugten Ritzgrabens gewählt. Damit wurde befunden, dass

bezüglich der heute bekannten, erwähnten Haftprüfverfahren die Titannitrid-beschichteten Schaftfräser und die mit Titannitrid beschichteten Schaftfräser mit Chromzwischenschicht keinen Unterschied aufwiesen.

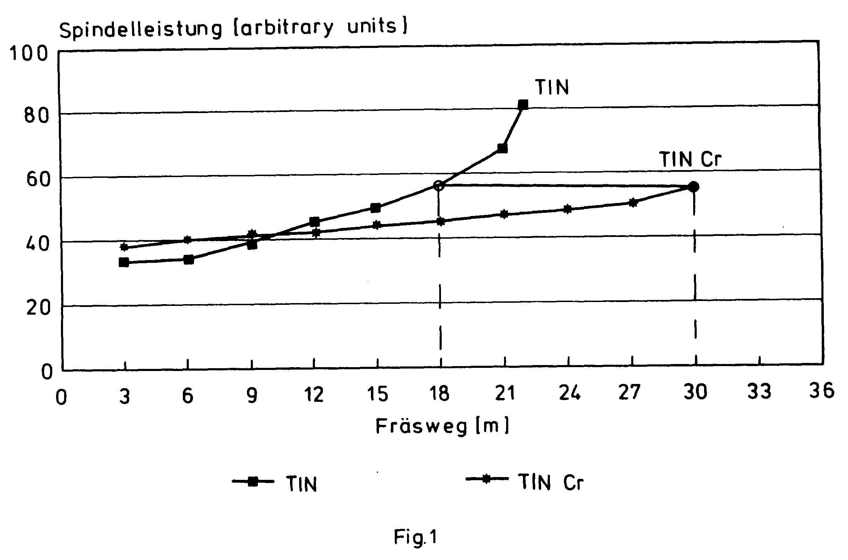

In Fig. 1 ist das Fräsverhalten der Fräser mit und ohne Chromzwischenschicht dargestellt. Dabei ist auf der y-Achse in Relativskalierung die Spindelleistung angegeben, auf der x-Achse, gemäss obigen Fräsbedingungen, der Fräsweg. Deutlich ist ersichtlich, dass die Fräser mit Chromzwischenschicht wesentlich längere Fräswege schaffen, bei tieferen Spindelleistungen, als die herkömmlichen Titannitrid-beschichteten Fräser, erstere mithin wesentlich längere Standzeiten aufweisen. Ein Standzeitvergleich ergibt sich beispielsweise durch Vergleich der Fräswege bei gleichen aufgebrachten Spindelleistungen, beispielsweise bei der in Fig. 1 eingetragenen Relativleistung von ca. 55, woraus sich eine praktisch 40%ige Erhöhung der Standzeit aufgrund der Chromzwischenschicht ergibt.

Beispiel 2:

Die oben für Beispiel 1 definierte Verdampfungsanlage wurde mit denselben Schaftfräsern wie in Beispiel 1 chargiert. Anstelle der dort eingesetzten 3g schweren Chromtablette wurde eine 8g schwere Chromtablette auf das Titan-Verdampfungsgut aufgelegt. Es entstand auf den Schaftfräsern eine ca. 400nm dicke Cr/CrN-Schicht zwischen Fräsersubstrat und nachfolgender Titannitridschicht mit einer Dicke von 4µm.

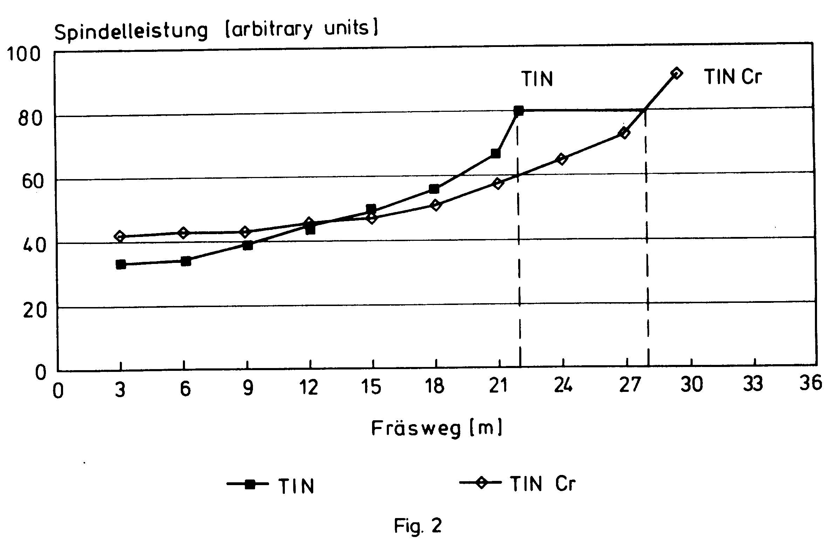

Die so beschichteten Schaftfräser wurden gemäss Fig. 2 wiederum bezüglich ihres Fräsverhaltens zur Standzeitermittlung mit den Titannitrid-beschichteten aus Beispiel 1 verglichen. Es ergibt sich, dass einerseits, auch bei diesem Beispiel, die Standzeiten der Fräser mit Chromzwischenschicht gegenüber den Fräsern ohne Chromzwischenschicht erhöht werden, ebenso der Schnittweg pro Spindelleistung, indem beispielsweise bei der relativen Spindelleistung 80 der Fräsweg für Fräser mit Chromzwischenschicht um ca. 20% erhöht wird, aber verglichen mit Beispiel 1 sind die erzielten Standzeiten in "Fräsweg"-Einheiten und pro aufgewendete Spindelleistung schlechter.

Mithin verschlechtert sich die Schaftfräser-Standzeit, wenn die erfindungsgemäss vorgesehene Chromzwischenschicht zu dick wird.

Es wurden wiederum die Haftprüfverfahren gemäss Beispiel 1 durchgeführt. Dabei zeigte sich, dass wiederum beim Ritztest mit Rockwelldiamant Lasten von 10kg überschritten werden konnten. Eine Untersuchung und Bewertung der Ritzspuren an den Fräsern mit Chromzwischenschicht nach Beispiel 1 und nach Beispiel 2 zeigte aber an den Fräsern nach Beispiel 2 eine deutlich geringere Schädigung des Schichtsubstratverbundes, dies auch bei Vergleichen mit den nach Beispiel 1 bzw. 2 mit metallischer Titanunterschicht versehenen Vergleichsfräsern. Dies zeigt, dass die herkömmliche Lehre von der Verbesserung der Haftung durch Chromschichten auf einer Fehlinterpretation der Haftungsversuche beruhte. Mitteldicke Chromunterschichten verbessern wohl das Resultat der Haftprüfungen, weil diese mitteldicken Chromschichten nach diesem Beispiel 2 den Materialverbund Substrat/Zwischenschicht/Verschleissschutzschicht duktiler machen, ein Kriterium, das aber für die Beurteilung der Werkzeugstandzeit nicht aussagekräftig ist.

Sowohl bei Beispiel 1 wie auch bei Beispiel 2 ist aus den zugeordneten Figuren 1 und 2 ersichtlich, dass die schnittigkeit der TiN-beschichteten Fräser höher ist als diejenige der erfindungsgemäss mit Chromzwischenschicht versehenen Fräser. Dieser geringfügige Nachteil, der ohne weiteres in Kauf genommen werden kann, beruht auf der Tatsache, dass aufgrund des Vorsehens der Chromzwischenschicht eine etwas erhöhte Schnittkantenrundung entsteht.

Beispiel 3:

An der Verdampfungsanlage gemäss Beispiel 1 wurden Spiralbohrer mit TiN beschichtet. Auch hier war die metallische-Me-Schicht dünner als 1nm, so dass sie die Epitaxie-Effekte zwischen den Mikrokristallen des Spiralbohrersubstrates und der darüber aufwachsenden Titannitridschicht nicht unterbrach. Die Dicke der Titannitridschicht betrug etwa 3,1µm. Als Bohrer wurden verwendet:

| Material | HSS (S 6-5-2), entsprechend DIN 1.3343 |
| Durchmesser $\phi$ | 6mm |
| Längen | 93 x 57mm (total x Schnitt-Teil) |
| von | Gühring, Deutschland |

Sie wurden nach ihrer TiN-Beschichtung folgendem Test unterzogen:

| Bohrmaterial | AISI D 3, entsprechend DIN 1.2080 |
| Zusammensetzung in % | C 1.65/Si 0.3/Mn 0.3/Cr 11.5/V 0.1 |
| von | Precision Steel, Schweden |
| Drehzahl | 1850U/min (gemäss $n = \frac{1000 \cdot V}{\pi \cdot \phi}$) |
| Vorschub S | 0,12mm pro Umdrehung (gemäss $S = \frac{60 \, L}{t \cdot n}$) |
| Schnittgeschwindigkeit v | 34,87m/min (gemäss $v = \frac{n \phi \pi}{1000}$) |
| Bohrungsart | 15mm tiefe Sackbohrungen (L) |
| mit | |
| L | Weg der Spindel (mm) |
| t | Zeit (sec) |

Es wurden Sacklöcher in die Testplatte mit einem Abstand von 7,5mm gebohrt. Als Kühlschmiermittel wurde Blasocut Universal 2000 eingesetzt.

Nach durchschnittlich 79 Bohrungen zeigten die TiN-beschichteten Bohrer so starke Verschleisserscheinungen, dass der Test abgebrochen werden musste.

Darnach wurden mit derselben Anlage die identischen Spiralbohrer identisch beschichtet, wobei aber vor der Titannitrid-Schichtbildung 4g Chrom verdampft wurde. Es ergab sich zwischen der weiterhin ca. 3,1μm dicken Titannitridschicht und dem Bohrersubstrat eine ca. 50nm dicke metallische Chromschicht, gefolgt von einer Chromnitrid/Chromschicht von ähnlicher Stärke, also eine erfindungsgemässe CrX-Schicht von ca. 100nm Dicke, bedingt durch den Stickstoffeinlass vor Einsetzen des Titanverdampfens. Die so beschichteten Bohrer wurden den gleichen Testbedingungen unterzogen. Es ergaben sich durchschnittlich 100 Bohrungen pro getesteten, erfindungsgemäss beschichteten Spiralbohrer.

Hieraus ergibt sich, dass durch Vorsehen der ca. 100nm Chrom/Chromnitridschicht sich eine wesentliche Erhöhung der Spiralbohrer-Standzeiten um ca. 20% ergab.

Beispiel 4:

An einer Anlage, wie sie in der US-A-4 877 505 (entsprechend der EP-A-0 306 612) dargestellt und beschrieben ist, und auch nach dem dort beschriebenen Verfahren, wurden dieselben Spiralbohrer wie in Beispiel 3 mit tanaluminiumnitrid beschichtet. Dabei wurde Titan magnetronzerstäubt und gleichzeitig Aluminium bogenverdampft, beides in einer Stickstoffatmosphäre. Dadurch wurde eine 4μm dicke TiAlN-Schicht aufgebaut. Die so beschichteten Bohrer wurden dem in Beispiel 3 beschriebenen Bohrtest unterzogen. Darnach wurden die identischen Spiralbohrer identisch beschichtet, jedoch indem auf das Aluminiumtiegel eine 4g Chromtablette aufgelegt wurde und vor Beginn des Titansputterns und des Aluminiumverdampfens Chrom verdampft wurde. So wurde zwischen das Spiralbohrersubstrat und die Titanaluminiumnitrid-Schicht eine ca. 50nm starke Cr/CrN-Schicht abgelegt. Die so erfindungsgemäss beschichteten Bohrer wurden auch dem bereits wähnten Bohrtest unterzogen.

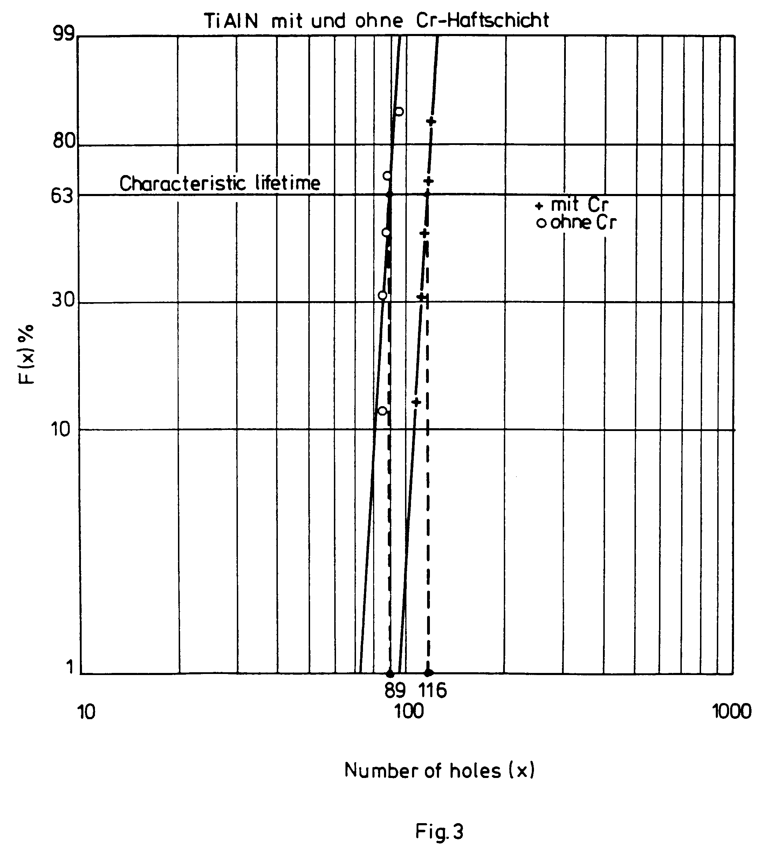

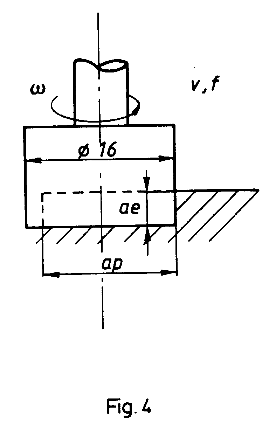

Es zeigt Fig. 3 die resultierende Weibull-Verteilung für die erwähnten Bohrer mit und ohne Chromzwischenschicht. Bekanntlich gilt für die Weibull-Verteilung F(x):

$$F(x) = 1 - \exp(-(x/T)^{\beta})$$

mit

T:   characteristic lifetime in Anzahl Löcher
β:   Formfaktor
x:   Lochzahl

Beispiel:

bei β = 8
T = 360 Löcher
x = 250

ist

$$F(x) = 0{,}052 \div 5{,}2\%,$$

d.h. bei dieser Verteilung sind 5,2% der zu erwartenden Bohrer-Lochzahlen kleiner als 250.

In Fig. 3 gilt:
β = 24,1
x Wert von T : 89.2 bzw. 116.1.

Daraus ist die Verbesserung der Bohrerstandzeiten durch Vorsehen der erfindungsgemässen Chromzwischenschicht deutlich erkennbar.

Obwohl es sich bei diesem Beispiel um ein anderes Beschichtungsverfahren handelt als in den Beispielen 1 bis 3 und ebenso um einen anderen Schichtwerkstoff, wurde mit der Chromzwischenschicht eine deutliche Leistungssteigerung erreicht. Aehnlich gute Resultate werden auch mit anderen Beschichtungsverfahren, wie reaktivem (AC- oder DC-)Kathodenzerstäuben, reaktivem Elektronenstrahlverdampfen oder reaktivem Heizverdampfen, auch reaktivem Bogenverdampfen, erzielt, generell durch reaktive PVD- oder plasmaunterstützte CVD-Verfahren erreicht.

Obwohl das erfindungsgemässe Vorsehen der Chrom- bzw. CrX-Zwischenschicht im Zusammenhang mit Titannitrid- und Titanaluminiumnitrid-Schichten beschrieben wurde, wurden ähnlich gute Resultate auch bei Titancarbonitrid-Schichten erzielt, und es wird mit hoher Wahrscheinlichkeit damit gerechnet, dass das erfindungsgemässe Vorsehen einer Chromzwischenschicht bei allen in Anspruch 1 spezifizierten Schichten Standzeitverbesserungen ergibt.

Beispiel 5:

Der Vergleich von auf identische Weise wie in Beispiel 3 mit dünner Cr-Schicht, dicker Cr-Schicht und ohne Cr-Schicht beschichteten Bohrern der in Beispiel 3 angegebenen Art, auch gemäss Beispiel 3 geprüft, ergibt folgendes:

|  | Charge 1 | Charge 2 | Charge 3 |
|---|---|---|---|
| Bogenstrom für Cr-Verdampfen | 80A | 140A | - |
| Zeitspanne Cr-Verdampfen | 4min | 4min | - |
| verdampfte Cr-Menge | 5g | 8g | - |
| Schichtdicke Cr+CrN | 0,2μm | 0,3μm | - |
| Schichtdicke Cr | <0,1μm | >0,1μm | - |
| Bohrergebnis | 70-80 Loch | 50-60 Loch | 20-30 Loch |
| max. Beschichtungstemperatur | 250°C | 250°C | 250°C |

Daraus ist klar ersichtlich, dass bereits bei Unterschreiten eines Dickengrenzwertes von 0,1μm eine wesentliche Verbesserung der Bohrerstandzeiten auftritt.

**Patentansprüche**

1. Verfahren zur Standzeiterhöhung von mit einer MeX-Verschleissschutzschicht beschichteten Werkzeugen, insbesondere spanabhebenden oder formenden Werkzeugen, worin

   Me ein Metall oder Mischmetall mit mindestens 50% mindestens eines Metalles der Gruppe IVb ist,

   X mindestens ein Metalloid der Gruppe C, O, N, B ist mit weniger als 50% Sauerstoff,

   wobei man zwischen Werkzeugsubstrat und der MeX-Beschichtung eine Zwischenschicht im wesentlichen aus CrX und Cr einbaut mit einer Stärke d von

$$5nm \leq d \leq 1000nm.$$

2. Verfahren nach Anspruch 1, wobei die Zwischenschicht mit der Stärke

$$5nm \leq d \leq 500nm$$

   eingebaut wird, vorzugsweise mit der Stärke

$$5nm \leq d \leq 400nm.$$

3. Verfahren nach Anspruch 2, dadurch gekennzeichnet, dass die Zwischenschicht mit der Stärke d von

$$10nm \leq d \leq 100nm$$

   eingebaut wird, vorzugsweise mit einer Stärke

$$d \approx 50nm.$$

4. Verfahren nach einem der Ansprüche 1 bis 3, dadurch gekennzeichnet, dass die Verschleissschutzschichtbeschichtung mit TiN, TiCN oder TiAlN vorgenommen wird.

**5.** Verfahren nach einem der Ansprüche 1 bis 4, dadurch gekennzeichnet, dass das Werkzeugsubstrat ein Stahl, vorzugsweise ein HSS-Stahl ist oder vorzugsweise ein Werkzeugstahl des Typs T oder M gemäss ASM-Norm.

**6.** Verfahren nach einem der Ansprüche 1 bis 5, dadurch gekennzeichnet, dass durch reaktives Verdampfen und/ oder reaktives Kathodenzerstäuben verschleissschutzbeschichtet wird und/oder zwischenbeschichtet wird.

**7.** Mit einer Verschleissschutzschicht MeX beschichtetes Werkzeug, insbesondere für spanabhebende oder formende Verarbeitung, worin

Me   ein Metall oder Mischmetall mit mindestens 50% mindestens eines Metalles der Gruppe IVb ist,

X     mindestens ein Metalloid der Gruppe C, O, N, B mit weniger als 50% Sauerstoff ist,

wobei zwischen Werkzeugsubstrat und der MeX-Verschleissschutzschicht eine Zwischenschicht im wesentlichen aus CrX und Cr bestehen mit einer Stärke d

$$5nm \leq d \leq 1000nm$$

vorgesehen ist.

**8.** Werkzeug nach Anspruch 7, dadurch gekennzeichnet, dass die Zwischenschicht eine Stärke von

$$5nm \leq d \leq 500nm$$

aufweist, dabei vorzugsweise von

$$5nm \leq d \leq 400nm.$$

**9.** Werkzeug nach Anspruch 8, dadurch gekennzeichnet, dass die Zwischenschicht eine Stärke von

$$10nm \leq d \leq 100nm$$

aufweist, dabei vorzugsweise eine Stärke von

$$d \approx 50nm.$$

**10.** Werkzeug nach einem der Ansprüche 7 bis 9, dadurch gekennzeichnet, dass die Verschleissschutzbeschichtung eine TiN-, TiCN- oder TiAlN-Beschichtung ist.

**11.** Werkzeug nach einem der Ansprüche 7 bis 10, dadurch gekennzeichnet, dass das Werkzeugsubstrat Stahl, vorzugsweise HSS-Stahl ist oder vorzugsweise ein Werkzeugstahl des Typs T oder M gemäss ASM-Norm.

**12.** Als Bohrer oder Fräser ausgebildetes Werkzeug nach einem der Ansprüche 7 bis 11.

**13.** Verschleissschutzsystem mit mindestens einer Verschleissschutzschicht MeX, worin

Me   ein Metall oder ein Mischmetall mit mindestens 50% mindestens eines Metalles der Gruppe IVb ist,

X     mindestens ein Metalloid der Gruppe C, O, N, B ist mit weniger als 50% Sauerstoff,

wobei weiter zwischen der erwähnten mindestens einen Verschleissschutzschicht und einem Trägersubstrat eine Zwischenschicht im wesentlichen aus CrX und Cr mit einer Stärke d von

$$5nm \leq d \leq 1000nm$$

eingebaut ist.

**14.** Verschleissschutzsystem nach Anspruch 13, dadurch gekennzeichnet, dass die Stärke d beträgt

$$5nm \leq d \leq 500nm.$$

## Revendications

**1.** Procédé pour augmenter la durabilité d'outils revêtus d'une couche anti-usure en MeX, en particulier d'outils d'enlèvement de copeaux ou de façonnage,

Me étant un métal ou un alliage contenant au moins 50 % d'au moins un métal du groupe IVb, et
X étant au moins un métalloïde du groupe C, O, N, B contenant moins de 50 % d'oxygène,

selon lequel on insère entre le substrat d'outil et le revêtement en MeX une couche intermédiaire composée essentiellement de CrX et de Cr d'une épaisseur d :

$$5 \text{ nm} \leq d \leq 1000 \text{ nm}.$$

**2.** Procédé selon la revendication 1, selon lequel on insère la couche intermédiaire suivant l'épaisseur

$$5 \text{ nm} \leq d \leq 500 \text{ nm},$$

de préférence suivant l'épaisseur

$$5 \text{ nm} \leq d \leq 400 \text{ nm}.$$

**3.** Procédé selon la revendication 2, caractérisé en ce qu'on insère la couche intermédiaire suivant l'épaisseur d

$$10 \text{ nm} \leq d \leq 100 \text{ nm},$$

de préférence suivant une épaisseur

$$d \approx 50 \text{ nm}.$$

**4.** Procédé selon l'une des revendications 1 à 3, caractérisé en ce qu'on applique la couche anti-usure avec du TiN, TiCN ou TiAlN.

**5.** Procédé selon l'une des revendications 1 à 4, caractérisé en ce que le substrat d'outil est un acier, de préférence un acier HSS ou de préférence un acier pour outil du type T ou M selon la norme ASM.

**6.** Procédé selon l'une des revendications 1 à 5, caractérisé en ce qu'on applique le revêtement anti-usure et/ou le revêtement intermédiaire par évaporation réactive et/ou par pulvérisation cathodique réactive.

**7.** Outil revêtu d'une couche anti-usure en MeX, en particulier pour l'usinage par enlèvement de copeaux ou par façonnage,

Me étant un métal ou un alliage contenant au moins 50 % d'au moins un métal du groupe IVb, et

X   étant au moins un métalloïde du groupe C, O, N, B contenant moins de 50 % d'oxygène,

étant précisé qu'il est prévu, entre le substrat d'outil et la couche anti-usure en MeX, une couche intermédiaire composée essentiellement de CrX et de Cr d'une épaisseur d :

$$5 \, nm \leq d \leq 1000 \, nm.$$

8. Outil selon la revendication 7, caractérisé en ce que la couche intermédiaire présente une épaisseur

$$5 \, nm \leq d \leq 500 \, nm,$$

de préférence

$$5 \, nm \leq d \leq 400 \, nm.$$

9. Outil selon la revendication 8, caractérisé en ce que la couche intermédiaire présente une épaisseur

$$10 \, nm \leq d \leq 100 \, nm,$$

de préférence

$$d \approx 50 \, nm.$$

10. Outil selon l'une des revendications 7 à 9, caractérisé en ce que le revêtement anti-usure est un revêtement en TiN, TiCN ou TiAlN.

11. Outil selon l'une des revendications 7 à 10, caractérisé en ce que le substrat d'outil est de l'acier, de préférence de l'acier HSS ou un acier pour outil du type T ou M selon la norme ASM.

12. Outil selon l'une des revendications 7 à 11 conçu comme un foret ou comme une fraise.

13. Système anti-usure comportant au moins une couche anti-usure en MeX,

Me   étant un métal ou un alliage contenant au moins 50 % d'au moins un métal du groupe IVb, et
X   étant au moins un métalloïde du groupe C, O, N, B contenant moins de 50 % d'oxygène,

étant précisé qu'on insère entre la ou les couches anti-usure mentionnées et un substrat une couche intermédiaire composée essentiellement de CrX et de Cr d'une épaisseur d :

$$5 \, nm \leq d \leq 1000 \, nm.$$

14. Système anti-usure selon la revendication 13, caractérisé en ce que l'épaisseur d est

$$5 \, nm \leq d \leq 500 \, nm.$$

## Claims

1. Process to extend the life of tools coated with an MeX wear protection layer, in particular chipping or forming tools, in which

Me  is a metal or composition metal with at least 50% of at least one metal of the group IVb,

X    is at least a metalloid of groups C, O, N, B with less than 50% oxygen,

where between the tool substrate and the MeX coating is incorporated an intermediate layer of essentially CrX and Cr with a thickness d of

$$5 \text{ nm} \leq d \leq 1000 \text{ nm}.$$

2. Process according to claim 1 where the intermediate layer has a thickness of

$$5 \text{ nm} \leq d \leq 500 \text{ nm}$$

preferably with thickness

$$5 \text{ nm} \leq d \leq 400 \text{ nm}.$$

3. Process according to claim 2, characterized in that the intermediate layer has a thickness d of

$$10 \text{ nm} \leq d \leq 100 \text{ nm},$$

preferably with thickness

$$d \approx 50 \text{ nm}.$$

4. Process according to any of claims 1 to 3, characterized in that the wear protection layer coating is made of TiN, TiCN or TiAlN.

5. Process according to any of claims 1 to 4, characterized in that the tool substrate is a steel, preferably an HSS steel or preferably a tooling steel of type T or M to ASM standard.

6. Process according to any of claims 1 to 5, characterized in that the wear protection coating and/or intermediate coating is applied by reactive vapour deposition and/or reactive cathode sputtering.

7. Tool coated with a wear protection layer MeX, in particular for chipping or forming work, where

Me  is a metal or composition metal with at least 50% of at least one metal of Group IVb,

X    is at least a metalloid of Groups C, O, N, B with less than 50% oxygen,

where between the tool substrate and the MeX wear protection layer is an intermediate layer essentially consisting of CrX and Cr with a thickness d of

$$5 \text{ nm} \leq d \leq 1000 \text{ nm}.$$

8. Tool according to claim 7, characterized in that the intermediate layer has a thickness of

$$5 \text{ nm} \leq d \leq 500 \text{ nm},$$

preferably

$$5 \text{ nm} \leq d \leq 400 \text{ nm}.$$

9. Tool according to claim 8, characterized in that the intermediate layer has a thickness of

$$10 \text{ nm} \leq d \leq 100 \text{ nm},$$

preferably a thickness of

$$d \approx 50 \text{ nm}.$$

10. Tool according to any of claims 7 to 9, characterized in that the wear protection layer is a TiN, TiCN or TiAlN coating.

11. Tool according to any of claims 7 to 10, characterized in that the tool substrate is steel, preferably HSS steel or preferably a tooling steel of type T or M to ASM standard.

12. Tool formed as a drill or milling cutter according to claims 7 to 11.

13. Wear protection system with at least one wear protection layer MeX, where

Me is a metal or composition metal with at least 50% of at least one metal of Group IVb

X is at least one metalloid of Group C, O, N, B with less than 50% oxygen,

where also between the said at least one wear protection layer and a carrier substrate is incorporated an intermediate layer essentially of CrX and Cr with a thickness d of

$$5 \text{ nm} \leq d \leq 100 \text{ nm}.$$

14. Wear protection system according to claim 13, characterised in that the thickness d is

$$5 \text{ nm} \leq d \leq 500 \text{ nm}.$$

Fig.1

Fig. 2

EP 0 616 050 B1

TiAlN mit und ohne Cr-Haftschicht

Characteristic lifetime

+ mit Cr
o ohne Cr

F(x)%

89 116

Number of holes (x)

Fig. 3

Fig. 4